# EUROPÄISCHE PATENTSCHRIFT

(11) **EP 1 205 027 B1**
(45) Veröffentlichungstag und Bekanntmachung des Hinweises auf die Patenterteilung: **11.06.2003**
(21) Anmeldenummer: 00949337.0
(22) Anmeldetag: 14.07.2000
(51) Int. Cl.: H03J 5/02

(54) **ABSTIMMVERFAHREN FÜR EINEN RUNDFUNKEMPFÄNGER, INSBESONDERE EINEN FERNSEHSIGNALEMPFÄNGER, SOWIE HIERMIT KORRESPONDIERENDER RUNDFUNKEMPFÄNGER**
TUNING METHOD FOR A RADIO RECEIVER, ESPECIALLY A TELEVISION SIGNAL RECEIVER, AND A CORRESPONDING RADIO RECEIVER
PROCEDE D'ACCORD POUR UN RECEPTEUR RADIO, NOTAMMENT UN RECEPTEUR DE SIGNAUX DE TELEVISION, ET RECEPTEUR RADIO CORRESPONDANT

(30) Priorität: 16.07.1999 DE 19933422
(43) Veröffentlichungstag der Anmeldung: 15.05.2002
(73) Patentinhaber: Interessengemeinschaft für Rundfunkschutzrechte GmbH, Schutzrechtsverwertung & Co. KG, 40210 Düsseldorf (DE)
(72) Erfinder: KELLER, Herbert, 83236 Übersee (DE); NEBEL, Paul, 83224 Staudach (DE)
(74) Vertreter: Kinnstätter, Klaus
(86) Internationale Anmeldenummer: EP0006712
(87) Internationale Veröffentlichungsnummer: WO01006649

(56) Entgegenhaltungen:
- DE-A- 4 225 052
- GB-A- 2 063 600
- US-A- 4 367 559
- HOWELL ET AL.: "A SYSTEMS APPROACH TO LOW-COST ELECTRONIC TUNING ADDRESS" IEEE TRANSACTIONS ON CONSUMER ELECTRONICS., Bd. ce-24, Nr. 3, August 1978 (1978-08), Seiten 408-418, XP002151918 IEEE INC. NEW YORK., US ISSN: 0098-3063 in der Anmeldung erwähnt

## Beschreibung

Die vorliegende Erfindung betrifft ein Abstimmverfahren für einen Rundfunkempfänger, insbesondere einen Fernsehsignalempfänger, wobei dem Rundfunkempfänger nacheinander mittels einer Bedieneinheit mindestens zwei Empfangskanäle vorgegeben werden, die verdrängend in einem Abstimmspeicher gespeichert werden, wobei der verdrängte Empfangskanal in einem Hauptspeicher gespeichert wird, wobei aufgrund eines Abrufbefehls der im Hauptspeicher gespeicherte Empfangskanal in den Abstimmspeicher ladbar ist, wobei der Rundfunkempfänger entsprechend dem jeweils im Abstimmspeicher gespeicherten Empfangskanal abgestimmt wird, wobei dem Rundfunkempfänger ein weiterer Empfangskanal vorgegeben wird, der im Abstimmspeicher gespeichert wird, wobei der weitere-Empfangskanal dem Rundfunkempfänger durch Betätigen einer +/- Taste der Bedieneinheit indirekt vorgegeben wird. Die vorliegende Erfindung betrifft ferner einen hiermit korrespondierenden Rundfunkempfänger.

Derartige Abstimmverfahren und die hiermit korrespondierenden Rundfunkempfänger sind z. B. aus der DE 30 42 851 C2 oder der US-A-4,367,559 bekannt. Die Rundfunkempfänger sind insbesondere als Satellitenempfänger, Videorecorder und als Fernsehgeräte bekannt.

Aus dem Aufsatz "A Systems Approach to Low-Cost Electronic Tuning Address" von B. Howell et al., IEEE Transactions on Consumer Electronics, Vol. CE-24, No. 3, Aug. 1978 ist ein Fernseher mit einem Hauptspeicher mit drei Speicherplätzen bekannt. Durch Tastendruck auf eine bestimmte Taste kann der Benutzer die in diesen Speicherplätzen gespeicherten Fernsehkanäle rollierend nacheinander aufrufen. Bei den in den drei Speicherplätzen gespeicherten Fernsehkanälen handelt es sich jeweils um die zuletzt eingestellten Fernsehkanäle. Bei Anwahl eines neuen Fernsehkanals wird dieser anstelle eines gespeicherten Fernsehkanals in den Hauptspeicher aufgenommen.

Aus der DE 42 25 052 A1 ist ein Rundfunkempfänger mit einem Speicher bekannt, in dem der letzte zuvor eingestellte Empfangskanal bzw. die letzten zuvor eingestellten Empfangskanäle abgespeichert und wieder aus ihm abrufbar ist bzw. sind. Das Abspeichern erfolgt stets und unbedingt.

Bei Rundfunkempfängern ist häufig eine sogenannte Favorit- bzw. Last-Funktion implementiert, mit der man den Rundfunkempfänger direkt wieder auf einen bestimmten Empfangskanal abstimmen kann, obwohl der Rundfunkempfänger in der Zwischenzeit auf einen oder mehrere andere Empfangskanäle abgestimmt wurde.

Die über die Empfangskanäle empfangenen Programme werden oftmals von Werbeblöcken unterbrochen. Während dieser Werbeblöcke wechselt ein Großteil der Benutzer (bei Fernsehsignalempfängern also der Zuschauer) für die Dauer des Werbeblocks von dem ursprünglich selektierten Programm auf ein anderes Programm, das über einen anderen Empfangskanal empfangen wird und zu diesem Zeitpunkt nicht von einem Werbeblock unterbrochen ist. Dennoch muß er von Zeit zu Zeit zu dem ursprünglich empfangenen Programm zurückkehren, um zu überprüfen, ob der Werbeblock noch andauert. Der Wechsel auf das ursprünglich selektierte Programm ist aufgrund der Speicherung des ursprünglich selektierten Empfangskanals leicht möglich.

Wenn der Werbeblock noch andauert, möchte der Benutzer in der Regel wieder auf den zwischenzeitlich selektierten Empfangskanal wechseln. Auch dies ist leicht möglich, weil beim Wechseln auf das ursprünglich selektierte Programm üblicherweise das zwischenzeitlich selektierte Programm abgespeichert wird. Wenn der Benutzer aber von dem zwischenzeitlich selektierten Programm aus ein weiteres Programm anwählt, weil es für ihn eventuell interessanter sein könnte, geht die Information über das zwischenzeitlich selektierte Programm verloren. Falls der Benutzer in einem solchen Fall wieder auf den zwischenzeitlich selektierten Empfangskanal wechseln möchte, kann dies je nach Zahl der empfangbaren Programme sehr mühsam werden, wenn sich der Benutzer den Empfangskanal nicht gemerkt hat.

Die Aufgabe der vorliegenden Erfindung besteht darin, eine Möglichkeit zu schaffen, mittels derer der Benutzer des Rundfunkempfängers auf einfache Weise auch das zwischenzeitlich selektierte Programm wieder auffinden kann.

Die Aufgabe wird für das Abstimmverfahren dadurch gelöst, daß kumulierend zum ersten Empfangskanal auch mindestens ein zweiter selektierter Empfangskanal in dem Hauptspeicher gespeichert wird, bis der Hauptspeicher gefüllt ist, daß aufgrund eines Abrufbefehls der zweite Empfangskanal in den Abstimmspeicher ladbar ist und daß der weitere Empfangskanal bei indirekter Kanalvorgabe nach Ablauf einer Speicherzeit von mehreren Sekunden seit dem Einspeichern des weiteren Empfangskanals im Abstimmspeicher verdrängend im Hauptspeicher gespeichert wird.

Denn dadurch kann sowohl der Empfangskanal des ursprünglich selektierten Programms als auch der Empfangskanal des zwischenzeitlich selektierten Programms aus dem Hauptspeicher in den Abstimmspeicher geladen werden, ohne daß bei indirekter Vorgabe übersprungene, nur kurz vorgegebene Empfangskanäle den Hauptspeicher - z. B. beim sogenannten Zappen - vorzeitig überschreiben.

Bei direkter Kanalvorgabe hingegen kann der weitere Empfangskanal stets verdrängend im Hauptspeicher abgespeichert werden.

Wenn die Anzahl von im Hauptspeicher gespeicherten Empfangskanälen zwei ist, verdrängt vorzugsweise der weitere Empfangskanal den einen der im Hauptspeicher gespeicherten Empfangskanäle nur bei direkter Kanalvorgabe. Bei indirekter Kanalvorgabe wird der andere der im Hauptspeicher gespeicherten Empfangskanäle verdrängt. Denn dann wird der eine Empfangskanal, über den das eigentlich gewünschte Programm empfangen wird, fast immer beibehalten.

Bei indirekter Kanalvorgabe können nach Ablauf einer Zusatzzeit, die allerdings erheblich größer sein muß als die Speicherzeit, z. B. 5 oder 10 Minuten, die im Hauptspeicher gespeicherten Empfangskanäle vertauscht werden.

Die Empfangskanäle sind nacheinander im Hauptspeicher abgespeichert worden. Bei mehr als zwei abgespeicherten Empfangskanälen ist es daher auch möglich, daß der weitere Empfangskanal den ältesten der abgespeicherten Empfangskanäle verdrängt. Prinzipiell ist diese Vorgehensweise zwar auch bei nur zwei abgespeicherten Empfangskanälen möglich. Bei nur zwei abgespeicherten Empfangskanälen besteht aber die Gefahr, daß der Empfangskanal des ursprünglich selektierten Programms verdrängt wird.

Wenn der Hauptspeicher in zwei Teilbereiche aufgeteilt ist, in mindestens einem der Teilbereiche mindestens zwei Empfangskanäle abspeicherbar sind und der weitere Empfangskanal bei direkter Kanalvorgabe im einen und bei indirekter Kanalvorgabe im anderen der Teilbereiche gespeichert wird, ist es möglich, die auf verschiedene Aufrufarten selektierten Empfangskanäle separat abzuspeichern. Innerhalb der Teilbereiche verdrängt dabei der weitere Empfangskanal weiterhin den ältesten der im jeweiligen Teilbereich abgespeicherten Empfangskanäle.

Die "Merkfähigkeit" des Abstimmverfahrens wird noch weiter erhöht, wenn bei direkter Kanaleingabe und nur unvollständig mit Empfangskanälen gefülltem anderem Teilbereich der verdrängte Empfangskanal im anderen Teilbereich gespeichert wird und bei indirekter Kanaleingabe und nur unvollständig mit Empfangskanälen gefülltem einem Teilbereich der verdrängte Empfangskanal im einen Teilbereich gespeichert wird. Eine teilbereichübergreifende Verdrängung findet aber nicht statt.

In Versuchen hat es sich als optimal herausgestellt, wenn bei teilbereichübergreifender Speicherung der verdrängte Empfangskanal in seinem neuen Teilbereich als ältester der im jeweiligen Teilbereich abgespeicherten Empfangskanäle gespeichert wird.

Wenn der weitere Empfangskanal aus dem Hauptspeicher abgerufen wird und nicht der jüngste der im Hauptspeicher abgespeicherten Empfangskanäle ist, wird bei Eintreten einer Ergänzungsbedingung der weitere Empfangskanal vorzugsweise als zweitjüngster Empfangskanal im Hauptspeicher bzw. im einen Teilbereich abgespeichert. Denn dann ist gewährleistet, daß der zuletzt als vorrangig gespeicherter Empfangskanal bei zwischenzeitlichen Aufrufen anderer im Hauptspeicher abgespeicherter Empfangskanäle weiterhin vorrangig bleibt.

Auch der Abruf der im Hauptspeicher abgespeicherten Empfangskanäle kann auf verschiedene Weise erfolgen.

Eine Möglichkeit ist, daß bei der ersten Eingabe des Abrufbefehls einer der im Hauptspeicher abgespeicherten Empfangskanäle und bei weiteren Eingaben des Abrufbefehls zyklisch je ein anderer der im Hauptspeicher abgespeicherten Empfangskanäle in den Abstimmspeicher geladen wird. Diese Vorgehensweise ist besonders dann sinnvoll, wenn im Hauptspeicher nur wenige Empfangskanäle abgespeichert sind. Bei nur zwei abgespeicherten Empfangskanälen stellt dies nur ein Austauschen dar, das über eine einzige Taste erfolgen kann. Bei mehr als zwei abgespeicherten Empfangskanälen kommt für diese Art des Kanalabrufs insbesondere ein Hoch- bzw. Tieftasten über eine +/- Taste in Frage.

Alternativ oder zusätzlich es es möglich, daß die im Hauptspeicher abgespeicherten Empfangskanäle durch die Abrufbefehle direkt abrufbar sind. Hier kommt insbesondere eine Eingabe über eine Zifferntastatur einer Bedieneinheit in Frage.

Bei direktem Abruf der Empfangskanäle kann eine Benutzerführung dadurch erfolgen, daß bei Eingabe eines Anzeigebefehls die im Hauptspeicher abgespeicherten Empfangskanäle auf einer Anzeigeeinheit angezeigt werden.

Die Benutzerführung ist noch besser, wenn zusammen mit den im Hauptspeicher abgespeicherten Empfangskanälen auf der Anzeigeeinheit angezeigt wird, wie die im Hauptspeicher abgespeicherten Empfangskanäle durch die Abrufbefehle direkt abrufbar sind.

Wenn bei einer weiteren Eingabe des Anzeigebefehls die Anzeige der im Hauptspeicher abgespeicherten Empfangskanäle wieder gelöscht wird, muß der momentan selektierte Empfangskanal nicht gewechselt werden. Es ist also z. B möglich, bei einer versehentlichen Eingabe des Anzeigebefehls diesen wieder zu löschen. Es auch möglich, die im Hauptspeicher abgespeicherten Empfangskanäle nur anzuzeigen, um hinterher zu wissen, welche Empfangskanäle zur Zeit im Hauptspeicher abgespeichert sind.

Wenn die Anzahl von Empfangskanälen vier ist, ist eine besonders einfache Auswahl möglich, wenn die Abrufbefehle einem Cursorkreuz zugeordnet sind. Auch kann in diesem Fall die Zuordnung der abgespeicherten Empfangskanäle zu den Abrufbefehlen durch die Anordnung der Information über die abgespeicherten Empfangskanäle auf der Anzeigeeinheit angezeigt werden. Wenn die Anzahl von Empfangskanälen mehr als vier ist, können die Abrufbefehle für die vier zuletzt im Hauptspeicher abgespeicherten Empfangskanäle dem Cursorkreuz zugeordnet sein.

Wenn über das Cursorkreuz im Regelfall andere Befehle für den Rundfunkempfänger eingegeben werden und die Abrufbefehle für die vier Empfangskanäle bzw. für die vier zuletzt im Hauptspeicher abgespeicherten Empfangskanäle dem Cursorkreuz erst durch das Betätigen einer Sondertaste zugeordnet werden, ist die Zahl an zusätzlich erforderlichen Bedienelementen der Bedieneinheit möglichst gering.

Wenn im Hauptspeicher mehr als zwei Empfangskanäle abgespeichert sind, ist der Bedienkomfort für den Rundfunkempfänger ist noch größer, wenn durch Betätigen eines Last-Elements der jüngste bzw. alternierend der jüngste und der zweitjüngste der im Hauptspeicher abgespeicherten Empfangskanäle abgerufen wird bzw. werden.

Weitere Vorteile und Einzelheiten ergeben sich aus den übrigen Ansprüchen sowie aus der nachfolgenden Beschreibung eines Ausführungsbeispiels in Verbindung mit den Figuren. Dabei zeigen in Prinzipdarstellung
- FIG 1: einen Fernsehempfänger als Beispiel eines Rundfunk- bzw. Fernsehsignalempfängers,
- FIG 2: ein Ablaufdiagramm,
- FIG 3: ein weiteres Ablaufdiagramm,
- FIG 4: eine Bedieneinheit,
- FIG 5: eine Anzeige einer Anzeigeeinheit und
- FIG 6: eine weitere Anzeige der Anzeigeeinheit.

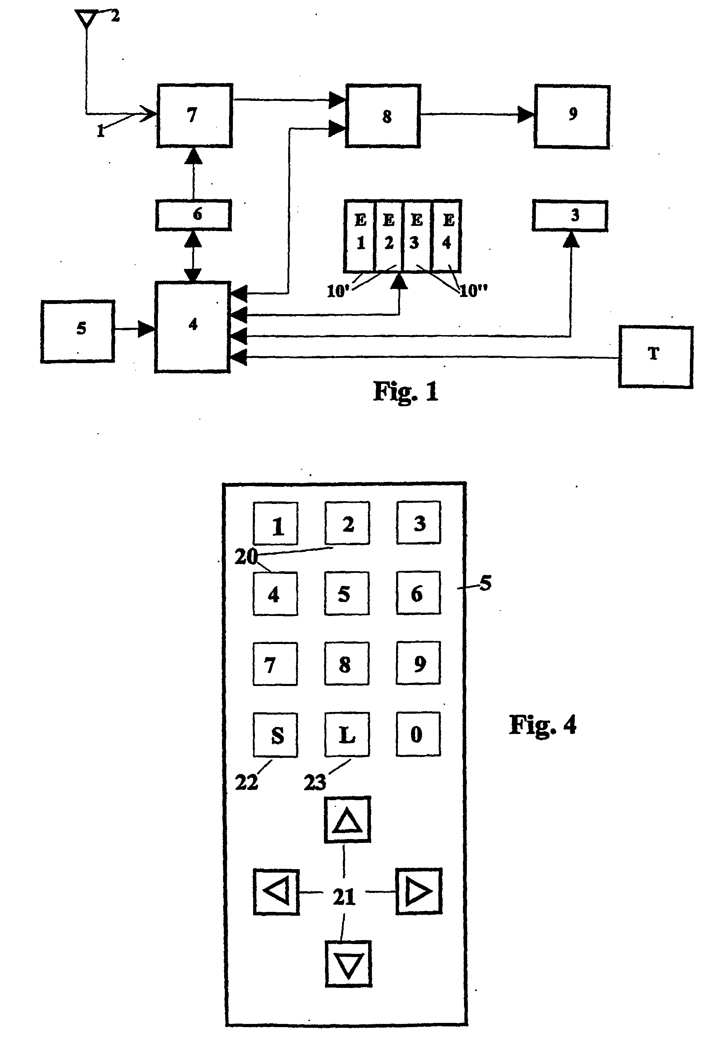

Gemäß FIG 1 weist ein Fernsehempfänger als Beispiel eines Rundfunk- bzw. Fernsehsignalempfängers einen Antennenanschluß 1 auf. An den Antennenanschluß 1 ist eine Antenne 2 angeschlossen. Über die Antenne 2 ist eine Vielzahl von Fernsehprogrammen empfangbar, wobei jedes Fernsehprogramm einem Empfangskanal entspricht. Die Begriffe "Fernsehprogramm" bzw. einfach "Programm" und "Empfangskanal" werden daher im folgenden synonym benutzt.

In einem Permanentspeicher 3 sind selektierbare Empfangskanäle abgespeichert. Um ein bestimmtes Fernsehprogramm zu empfangen, wird einer Steuereinheit 4 für den Fernsehempfänger mittels einer Bedieneinheit 5 ein Empfangskanal vorgegeben. Die Steuereinheit 4 lädt daraufhin den vorgegebenen Empfangskanal in einem Abstimmspeicher 6. Der Inhalt des Abstimmspeichers 6 legt die Abstimmung eines Tuners 7 fest. Der Fernsehempfänger wird also stets auf den im Abstimmspeicher 6 gespeicherten Empfangskanal abgestimmt. Das aufgrund der Abstimmung des Tuners 7 selektierte Programm wird dann über einen Mischer 8 auf einem Monitor 9 dargestellt.

Der Fernsehempfänger weist einen Hauptspeicher 10 auf, der seinerseits eine Anzahl von Speicherplätzen zum Speichern je eines Empfangskanals aufweist. Die Anzahl von Speicherplätzen ist beliebig. Mindestens beträgt sie aber zwei.

Beim Einschalten des Fernsehempfängers ist der Hauptspeicher 10 zunächst leer. Bei jedem Wechsel des selektierten Programms, also bei jeder neuen Eingabe eines Empfangskanals, wird der neu vorgegebene Empfangskanal zunächst in den Abstimmspeicher 6 geladen. Der zuvor dort gespeicherte Empfangskanal wird aus dem Abstimmspeicher 6 verdrängt. Ferner wird der neu vorgegebene Empfangskanal aus dem Abstimmspeicher 6 in den Hauptspeicher 10 übertragen und dort kumulierend zusammen mit den zuvor abgespeicherten Empfangskanälen gespeichert, bis der Hauptspeicher 10 vollständig gefüllt ist.

Die im Hauptspeicher 10 gespeicherten Empfangskanäle können aufgrund von Abrufbefehlen, die über die Bedieneinheit 5 eingegeben werden, aus dem Hauptspeicher 10 abgerufen und in den Abstimmspeicher 6 geladen werden. Somit ist auf einfache Weise ein "Retracing" von zuvor selektierten Programmen möglich.

Wenn der Hauptspeicher 10 gefüllt ist, ist bei Vorgabe eines weiteren Empfangskanals nur eine verdrängende Speicherung des weiteren Empfangskanals im Hauptspeicher 10 möglich. Der weitere Empfangskanal wird zwar sofort verdrängend im Abstimmspeicher 6 gespeichert. Um aber zu verhindern, daß der Inhalt des Hauptspeichers 10 bei jedem kurzfristigen Wechsel des Empfangskanals überschrieben wird, wird der weitere Empfangskanal von der Steuereinheit 4 im Hauptspeicher 10 nur bei Eintreten einer Speicherbedingung gespeichert. Die Prüfung, ob die Speicherbedingung eingetreten ist oder nicht, wird von der Steuereinheit 4 vorgenommen. Diese wirkt also als Vergleichseinheit, die nur bei Eintreten der Speicherbedingung das Speichern des im Abstimmspeicher 6 gespeicherten Empfangskanals in den Hauptspeicher 10 bewirkt.

Der weitere Empfangskanal kann dem Fernsehempfänger durch direkte Eingabe (z. B. die Zifferntastatur der Bedieneinheit 5) oder über eine +/- Taste vorgegeben werden. Bei direkter Eingabe ist die Speicherbedingung gemäß Ausführungsbeispiel stets erfüllt. Bei Eingabe über eine +/- Taste ist die Speicherbedingung gemäß Ausführungsbeispiel dann erfüllt, wenn seit der letzten Betätigung der +/- Taste eine Speicherzeit von z. B. 10 oder 20 Sekunden verstrichen ist.

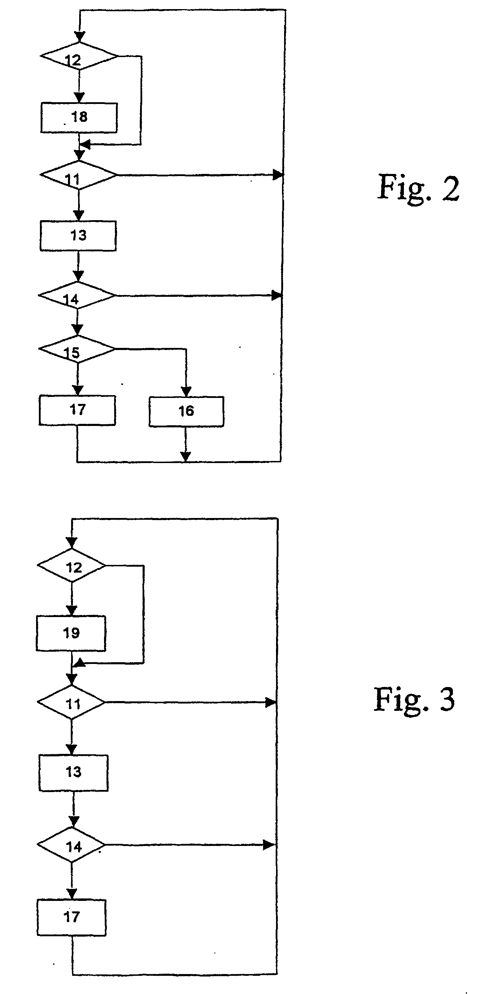

Wenn die Anzahl von Speicherplätzen genau zwei ist, wird vorzugsweise wie in FIG 2 dargestellt verfahren. Zur Unterscheidung sind die Speicherplätze dabei im folgenden als E1 und E2 bezeichnet.

Gemäß FIG 2 wird zunächst in einem Schritt 11 abgefragt, ob über die Bedieneinheit 5 eine Eingabe erfolgt ist. Wenn nicht, wird zu einem Schritt 12 verzweigt. Wenn ja, wird die Eingabe in einem Schritt 13 ausgeführt und mit einem Schritt 14 fortgefahren.

Im Schritt 14 wird abgefragt, ob der Inhalt des Abstimmspeichers 6 geändert wurde. Wenn nicht, wird wieder zum Schritt 12 verzweigt. Wenn ja, wird in einem Schritt 15 abgefragt, ob der Inhalt des Abstimmspeichers 6 über eine Eingabe mit einer +/- Taste geändert wurde.

Wenn der Inhalt des Abstimmspeichers 6 nicht über eine Eingabe mit einer +/- Taste geändert wurde, wurde der weitere Empfangskanal direkt vorgegeben. In diesem Fall sind sowohl die Speicher- als auch die Zusatzbedingung erfüllt. Dann wird in einem Schritt 16 der Inhalt des einen Speicherplatzes E1 in den Speicherplatz E2 umgespeichert. Der vorherige Inhalt des Speicherplatzes E2 wird verdrängt. Der Inhalt des Abstimmspeichers 6 wird im Speicherplatz E1 abgespeichert. Sodann wird zum Schritt 12 verzweigt.

Wenn der Inhalt des Abstimmspeichers 6 über eine Eingabe mit einer +/- Taste geändert wurde, wird in einem Schritt 17 ein Timer T auf 0 gesetzt und gestartet. Sodann wird wieder zum Schritt 12 verzweigt.

Im Schritt 12 wird abgefragt, ob der Timer T abgelaufen ist. Wenn nicht, wird zum Schritt 11 verzweigt. Wenn ja, ist seit der Änderung des Inhalts des Abstimmspeichers 6 über eine Eingabe mit einer +/- Taste die Speicherzeit verstrichen. Dann wird in einem Schritt 18 der Inhalt des Abstimmspeichers 6 im Speicherplatz E2 abgespeichert. Der vorherige Inhalt des Speicherplatzes E2 wird verdrängt.

Bei Ablauf des Timers T ist also zwar die Speicherbedingung, nicht aber die Zusatzbedingung erfüllt.

Wenn die Anzahl von Speicherplätzen größer als zwei ist, wird vorzugsweise wie in FIG 3 dargestellt verfahren. In FIG 3 ist dabei angenommen, daß die Anzahl von Speicherplätzen vier ist. Zur Unterscheidung sind die Speicherplätze dabei im folgenden als E1 bis E4 bezeichnet. Es ist aber auch eine andere Anzahl von Speicherplätzen möglich, z. B. acht oder zehn.

Die Empfangskanäle sind nacheinander im Hauptspeicher 10 abgespeichert worden. Im Speicherplatz E1 ist dabei der zuletzt abgespeicherte Empfangskanal abgespeichert, im Speicherplatz E4 der zuerst abgespeicherte Empfangskanal. Der im Speicherplatz E1 abgespeicherte Empfangskanal ist also der jüngste Empfangskanal, der im Speicherplatz E4 abgespeicherte der älteste.

Ebenso wie bei FIG 2 wird auch bei FIG 3 zunächst im Schritt 11 abgefragt, ob über die Bedieneinheit 5 eine Eingabe erfolgt ist. Wenn nicht, wird zum Schritt 12 verzweigt. Wenn ja, wird die Eingabe im Schritt 13 ausgeführt und mit dem Schritt 14 fortgefahren.

Im Schritt 14 wird wieder abgefragt, ob der Inhalt des Abstimmspeichers 6 geändert wurde. Wenn nicht, wird wieder zum Schritt 12 verzweigt. Wenn ja, wird im Schritt 17 der Timer T auf 0 gesetzt und gestartet. Sodann wird wieder zum Schritt 12 verzweigt.

Im Schritt 12 wird abgefragt, ob der Timer T abgelaufen ist. Wenn nicht, wird zum Schritt 11 verzweigt. Wenn ja, ist seit der Änderung des Inhalts des Abstimmspeichers 6 die Speicherzeit verstrichen. Dann ist die Speicherbedingung erfüllt. In diesem Fall wird in einem Schritt 19 der Inhalt des Hauptspeichers 10 aktualisiert. Hierzu wird der Inhalt des Speicherplatzes E3 in den Speicherplatz E4 umgespeichert, der des Speicherplatzes E2 in den Speicherplatz E3 und der des Speicherplatzes E1 in den Speicherplatz E2. Der Inhalt des Abstimmspeichers 6 wird im Speicherplatz E1 abgespeichert.

Der Bedienkomfort des Fernsehempfängers ist noch größer. wenn der Hauptspeicher 10 in zwei Teilbereiche 10', 10" aufgeteilt ist. Gemäß Ausführungsbeispiel weist dabei jeder Teilbereich 10', 10" zwei der Speicherplätze E1 bis E4 auf, so daß in jedem Teilbereich 10', 10" zwei Empfangskanäle abspeicherbar sind.

Wenn nun ein Empfangskanal über die Zifferntastatur direkt vorgegeben wird, also Speicher- und Zusatzbedingung erfüllt sind, wird der neu vorgegebene Empfangskanal im Speicherplatz E1 abgespeichert. Der zuvor im Speicherplatz E1 abgespeicherte Empfangskanal wird auf den Speicherplatz E2 umgespeichert. Wenn nun der Speicherplatz E3 noch leer ist, wird der zuvor im Speicherplatz E2 abgespeicherte Empfangskanal auf den Speicherplatz E3 umgespeichert. Ist der Speicherplatz E3 hingegen bereits vom Speicherplatz E4 aus belegt worden, geht der zuvor im Speicherplatz E2 abgespeicherte Empfangskanal verloren. Solange auch der Speicherplatz E4 noch leer ist, können bei direkter Kanalvorgabe über die Zifferntastatur sogar zwei Empfangskanäle aus dem Teilbereich 10' in den Teilbereich 10" umgespeichert werden.

Wenn hingegen ein Empfangskanal über die +/- Taste indirekt vorgegeben wird und die Speicherzeit abgelaufen ist, also nur die Speicherbedingung erfüllt ist, wird der neu vorgegebene Empfangskanal im Speicherplatz E4 abgespeichert. Der zuvor im Speicherplatz E4 abgespeicherte Empfangskanal wird auf den Speicherplatz E3 umgespeichert. Wenn nun der Speicherplatz E2 noch leer ist, wird der zuvor im Speicherplatz E3 abgespeicherte Empfangskanal auf den Speicherplatz E2 umgespeichert. Ist der Speicherplatz E2 hingegen bereits vom Speicherplatz E1 aus belegt worden, geht der zuvor im Speicherplatz E3 abgespeicherte Empfangskanal verloren. Solange auch der Speicherplatz E1 noch leer ist, können bei indirekter Kanalvorgabe über die +/- Taste ebenfalls zwei Empfangskanäle aus dem Teilbereich 10" in den Teilbereich 10' umgespeichert werden.

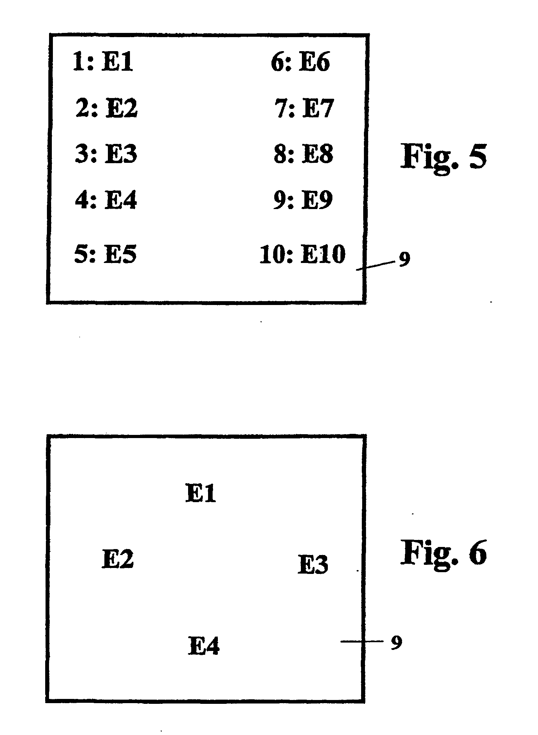

Der Abruf der im Hauptspeicher 10 abgespeicherten Empfangskanäle und das folgende Laden in den Abstimmspeicher 6 kann je nach Ausgestaltung der Bedieneinheit 5 ebenfalls auf verschiedene Weise erfolgen. Daher wird nachfolgend zunächst in Verbindung mit FIG 4 die Bedieneinheit 5 näher beschrieben.

Gemäß FIG 4 weist die Bedieneinheit 5 Zifferntasten 20 auf. Mittels der Zifferntasten 20 ist insbesondere eine direkte Eingabe eines Empfangskanals möglich. Die Bedieneinheit 5 weist ferner vier Cursortasten 21 auf. Mittels der beiden seitlichen Cursortasten 21 ist insbesondere eine Einstellung der Lautstärke möglich. Mittels der oberen und der unteren Cursortaste 21 ist insbesondere eine indirekte Eingabe eines Empfangskanals durch Hoch-/Tieftasten möglich. Die obere und die untere Cursortaste 21 haben also die Funktion von +/- Tasten. Die Cursortasten 21 bilden zusammen ein Cursorkreuz. Schließlich weist die Bedieneinheit 5 noch eine Sondertaste 22 und eine Last-Taste 23 auf.

Die Bedieneinheit 5 kann darüber hinaus noch weitere Bedienelemente aufweisen. Diese weiteren Bedienelemente sind aber im Rahmen der vorliegenden Erfindung nicht von Bedeutung und daher in FIG 4 nicht dargestellt.

Wenn im Hauptspeicher 10 nur wenige Empfangskanäle abgespeichert sind - z. B. zwei oder vier -, stellt das Betätigen der Sondertaste 22 vorzugsweise eine Eingabe eines Abrufbefehls dar. Dann wird bei der ersten Eingabe des Abrufbefehls einer der im Hauptspeicher 10 abgespeicherten Empfangskanäle aus dem Hauptspeicher 10 in den Abstimmspeicher 6 geladen. Bei weiteren Eingaben des Abrufbefehls wird dann zyklisch je ein anderer der im Hauptspeicher 10 abgespeicherten Empfangskanäle in den Abstimmspeicher 6 geladen.

Welcher der im Hauptspeicher 10 abgespeicherten Empfangskanäle als erster aus dem Hauptspeicher 10 in den Abstimmspeicher 6 geladen wird, ist prinzipiell frei wählbar. Insbesondere kann z. B. stets der jüngste oder stets der älteste abgespeicherte Empfangskanal in den Abstimmspeicher 6 geladen werden. Bei dem Speicherverfahren gemäß FIG 2 ist es auch möglich, stets den im Speicherplatz E1 gespeicherten Empfangskanal oder den vor dem letzten Programmwechsel durch Zappen zuletzt abgerufenen Empfangskanal abzurufen.

Alternativ ist es möglich, daß die im Hauptspeicher 10 abgespeicherten Empfangskanäle direkt abrufbar sind. In diesem Fall stellt das Betätigen der Sondertaste 22 nur eine Eingabe eines Vorbefehl für einen Abrufbefehl dar. Wenn im Hauptspeicher 10 bis zu vier Empfangskanäle abgespeichert sind, kann der eigentliche Abrufbefehl alternativ auch durch Betätigen einer der Cursortasten 21 ausgelöst werden. Wenn im Hauptspeicher 10 z. B. bis zu zehn Empfangskanäle abgespeichert sind, kann der eigentliche Abrufbefehl durch Betätigen einer der Zifferntasten 20 ausgelöst werden. Zusätzlich können ggf. auch die vier zuletzt in den Hauptspeicher 10 eingespeicherten Empfangskanäle durch Betätigen einer der Cursortasten 21 aufgerufen werden.

Bei direkter Eingabe des Abrufbefehls ist es möglich, diesen durch Betätigen der Sondertaste 22 mit nachfolgendem Betätigen einer der Zifferntasten 20 bzw. einer der Cursortasten 21 auszulösen, ohne weitere Maßnahmen zu ergreifen. Bei mehreren im Hauptspeicher 10 abgespeicherten Empfangskanälen besteht aber eine hohe Wahrscheinlichkeit, daß der Benutzer nicht genau weiß, welcher Empfangskanal auf welchem Speicherplatz abgespeichert ist. Er weiß also nicht, welche der Zifferntasten 20 bzw. welche der Cursortasten 21 er betätigen muß, um den von ihm gewünschten Empfangskanal abzurufen. Vorzugsweise sind daher die im Hauptspeicher 10 abgespeicherten Empfangskanäle auf dem Monitor 9 anzeigbar.

Wird die Sondertaste 22 erstmals betätigt, wirkt dies als Anzeigebefehl, aufgrund dessen die im Hauptspeicher 10 abgespeicherten Empfangskanäle auf dem Monitor 9 angezeigt werden. Dabei wird zusammen mit den im Hauptspeicher 10 abgespeicherten Empfangskanälen auf dem Monitor 9 angezeigt, wie die im Hauptspeicher 10 abgespeicherten Empfangskanäle direkt abrufbar sind.

Wenn im Hauptspeicher 10 z. B. bis zu zehn Empfangskanäle abgespeichert sind, kann gemäß FIG 5 auf dem Monitor 9 in Form einer Tabelle dargestellt werden, durch welche der Zifferntasten 20 welches Programm aus dem Hauptspeicher 10 abrufbar ist. Wenn im Hauptspeicher 10 z. B. bis zu vier Empfangskanäle abgespeichert sind, kann gemäß FIG 6 auf dem Monitor 9 durch eine entsprechende Anordnung der im Hauptspeicher abgespeicherten Empfangskanäle dargestellt werden, durch welche der Cursortasten 21 welches Programm aus dem Hauptspeicher 10 abrufbar ist. Wird die Sondertaste 22 nochmals betätigt, bevor eine der. Zifferntasten 20 bzw. der Cursortasten 21 betätigt wird, so wirkt dies als Löschbefehl, aufgrund dessen die Anzeige der im Hauptspeicher 10 abgespeicherten Empfangskanäle wieder gelöscht wird.

Es ist auch möglich, bei der ersten Betätigung der Sondertaste 22 die vier zuletzt in den Hauptspeicher 10 eingespeicherten Empfangskanäle in der Anordnung eines Cursorkreuzes darzustellen, so daß bei Betätigung einer der Cursortasten 21 der gewünschte Empfangskanal abgerufen wird. Bei einer zweiten Betätigung der Sondertaste 22 werden dann alle zehn in den Hauptspeicher 10 eingespeicherten Empfangskanäle als Liste bzw. Tabelle dargestellt, so daß bei Betätigung einer der Zifferntasten 20 der gewünschte Empfangskanal abgerufen wird. Bei der dritten Betätigung der Sondertaste 22 wird dann die Liste bzw. Tabelle wieder ausgeblendet.

Das Anzeigen der im Hauptspeicher 10 abgespeicherten Empfangskanäle kann dabei alternativ oder zusätzlich zu dem Programm erfolgen, das über den Tuner 7 empfangen wird.

Außer durch direkte und indirekte Vorgabe kann ein Empfangskanal selbstverständlich auch durch Abruf aus dem Hauptspeicher 10 in den Abstimmspeicher 6 geladen werden. Wenn der Hauptspeicher 10 - wie gemäß Ausführungsbeispiel der Fall - mindestens vier Speicherplätze E1 bis E4 aufweist und einer der in den Speicherplätzen E3 und E4 abgespeicherten Empfangskanäle in den Abstimmspeicher 6 geladen wird, so wird bei Eintreten einer Ergänzungsbedingung der Inhalt des Abstimmspeichers 6 im Speicherplatz E2 abgespeichert. Der zuvor im Speicherplatz E2 abgespeicherte Empfangskanal wird auf den Speicherplatz E3 umgespeichert. Wenn der im Speicherplatz E4 abgespeicherte Empfangskanal in den Abstimmspeicher 6 geladen wurde, wird darüber hinaus noch der zuvor im Speicherplatz E3 abgespeicherte Empfangskanal auf den Speicherplatz E4 umgespeichert. Im Ergebnis wird also der in den Abstimmspeicher 6 geladene Empfangskanal als zweitjüngster Empfangskanal im Hauptspeicher 10 bzw. im einen Teilbereich 10' abgespeichert wird.

Die Ergänzungsbedingung kann analog der Speicherbedingung z. B. ein Zeitablauf sein.

Bei mehr als zwei im Hauptspeicher 10 abgespeicherten Empfangskanälen ist ein Abruf der abgespeicherten Empfangskanäle in der Regel mit einer Betätigung von mindestens zwei Tasten 20, 21, 22 verbunden, nämlich Betätigung der Sondertaste 22 und Betätigung einer der Tasten 20, 21. Der Bedienkomfort kann daher durch die Last-Taste 23 erhöht werden. Bei Betätigung der Last-Taste 23 wird direkt der im Speicherplatz E1 abgespeicherte Empfangskanal aus dem Hauptspeicher 10 in den Abstimmspeicher 6 geladen. Alternativ ist auch möglich, alternierend die in den Speicherplätzen E1 und E2 abgespeicherten Empfangskanäle in den Abstimmspeicher 6 zu laden.

### Bezugszeichenliste

- 1: Antennenanschluß
- 2: Antenne
- 3: Permanentspeicher
- 4: Steuereinheit
- 5: Bedieneinheit
- 6: Abstimmspeicher
- 7: Tuner
- 8: Mischer
- 9: Monitor
- 10: Hauptspeicher
- 10', 10": Teilbereiche
- 11 - 19: Schritte
- 20 - 23: Tasten

- E1 - E4: Speicherplätze
- T: Timer

## Patentansprüche

1. Abstimmverfahren für einen Rundfunkempfänger, insbesondere einen Fernsehsignalempfänger,
- wobei dem Rundfunkempfänger mittels einer Bedieneinheit (5) nacheinander mindestens zwei Empfangskanäle vorgegeben werden,
- wobei die Empfangskanäle verdrängend in einem Abstimmspeicher (6) und kumulierend in einem Hauptspeicher (10) gespeichert werden, bis der Hauptspeicher (10) gefüllt ist,
- wobei aufgrund von Abrufbefehlen einer der im Hauptspeicher (10) gespeicherten Empfangskanäle in den Abstimmspeicher (6) ladbar ist,
- wobei der Rundfunkempfänger entsprechend dem jeweils im Abstimmspeicher (6) gespeicherten Empfangskanal abgestimmt wird,
- wobei dem Rundfunkempfänger ein weiterer Empfangskanal vorgegeben wird, der im Abstimmspeicher (6) gespeichert wird,
- wobei der weitere Empfangs kanal, wenn er dem Rundfunkempfänger durch Betätigen einer +/- Taste (21) der Bedieneinheit (5) indirekt vorgegeben wird, bei gefülltem Hauptspeicher (10) nach Ablauf einer Speicherzeit von mehreren Sekunden seit dem Einspeichern des weiteren Empfangskanals im Abstimmspeicher (6) verdrängend im Hauptspeicher (10) gespeichert wird.

2. Abstimmverfahren nach Anspruch 1, **dadurch gekennzeichnet, daß** der weitere Empfangskanal, wenn er dem Rundfunkempfänger direkt vorgegeben wird, stets verdrängend im Hauptspeicher (10) gespeichert wird.

3. Abstimmverfahren nach Anspruch 2, **dadurch gekennzeichnet, daß** die Anzahl von im Hauptspeicher (10) gespeicherten Empfangskanälen zwei ist und daß bei direkter Kanalvorgabe der weitere Empfangskanal den einen und bei indirekter Kanalvorgabe den anderen der im Hauptspeicher (10) gespeicherten Empfangskanäle verdrängt.

4. Abstimmverfahren nach Anspruch 3, **dadurch gekennzeichnet, daß** bei direkter Kanalvorgabe innerhalb des Hauptspeichers (10) der eine Empfangskanal den anderen Empfangskanal verdrängt.

5. Abstimmverfahren nach Anspruch 3 oder 4, **dadurch gekennzeichnet, daß** bei indirekter Kanalvorgabe nach Ablauf einer Zusatzzeit, die erheblich größer als die Speicherzeit ist, der eine Empfangskanal und der andere Empfangskanal vertauscht werden.

6. Abstimmverfahren nach Anspruch 1, **dadurch gekennzeichnet, daß** der weitere Empfangskanal den ältesten der abgespeicherten Empfangskanäle verdrängt.

7. Abstimmverfahren nach Anspruch 1, **dadurch gekennzeichnet, daß** der Hauptspeicher (10) in zwei Teilbereiche (10', 10") aufgeteilt ist, daß in mindestens einem der Teilbereiche (10', 10") mindestens zwei Empfangskanäle abspeicherbar sind und daß der weitere Empfangskanal bei direkter Kanalvorgabe im einen und bei indirekter Kanalvorgabe im anderen der Teilbereiche (10', 10") gespeichert wird.

8. Abstimmverfahren nach Anspruch 7, **dadurch gekennzeichnet, daß** die Empfangskanäle nacheinander in den Teilbereichen (10', 10") abgespeichert worden sind und daß der weitere Empfangskanal den ältesten der im jeweiligen Teilbereich (10', 10") abgespeicherten Empfangskanäle verdrängt.

9. Abstimmverfahren nach Anspruch 8, **dadurch gekennzeichnet, daß** bei direkter Kanalvorgabe und nur unvollständig mit Empfangskanälen gefülltem anderem Teilbereich (10") der verdrängte Empfangskanal im anderen Teilbereich (10") gespeichert wird und bei indirekter Kanalvorgabe und nur unvollständig mit Empfangskanälen gefülltem einem Teilbereich (10') der verdrängte Empfangskanal im einen Teilbereich (10') gespeichert wird.

10. Abstimmverfahren nach Anspruch 9, **dadurch gekennzeichnet, daß** der verdrängte Empfangskanal in seinem neuen Teilbereich (10', 10") als ältester der im jeweiligen Teilbereich (10', 10") abgespeicherten Empfangskanäle gespeichert wird.

11. Abstimmverfahren nach Anspruch 6, 8, 9 oder 10, **dadurch gekennzeichnet, daß** der weitere Empfangskanal aus dem Hauptspeicher (10) abgerufen wird, daß der weitere Empfangskanal nicht der jüngste der im Hauptspeicher (10) abgespeicherten Empfangskanäle ist und daß der weitere Empfangskanal bei Eintreten einer Ergänzungsbedingung als zweitjüngster Empfangskanal im Hauptspeicher (10) bzw. im einen Teilbereich (10') abgespeichert wird.

12. Abstimmverfahren nach einem der Ansprüche 1 bis 11, **dadurch gekennzeichnet, daß** bei der ersten Eingabe des Abrufbefehls einer und bei weiteren Eingaben des Abrufbefehls zyklisch je ein anderer der im Hauptspeicher (10) abgespeicherten Empfangskanäle in den Abstimmspeicher (6) geladen wird.

13. Abstimmverfahren nach einem der Ansprüche 1 bis 12, **dadurch gekennzeichnet, daß** die im Hauptspeicher (10) abgespeicherten Empfangskanäle durch die Abrufbefehle direkt abrufbar sind.

14. Abstimmverfahren nach einem der Ansprüche 1 bis 13, **dadurch gekennzeichnet, daß** bei Eingabe eines Anzeigebefehls die im Hauptspeicher (10) abgespeicherten Empfangskanäle auf einer Anzeigeeinheit angezeigt werden.

15. Abstimmverfahren nach Anspruch 13 oder 14, **dadurch gekennzeichnet, daß** zusammen mit einer Anzahl von im Hauptspeicher (10) abgespeicherten Empfangskanälen auf der Anzeigeeinheit (9) angezeigt wird, wie diese Empfangskanäle durch die Abrufbefehle direkt abrufbar sind.

16. Abstimmverfahren nach Anspruch 14 oder 15, **dadurch gekennzeichnet, daß** bei einer weiteren Eingabe des Anzeigebefehls die Anzeige der im Hauptspeicher (10) abgespeicherten Empfangskanäle wieder gelöscht wird.

17. Abstimmverfahren nach Anspruch 14, 15 oder 16, **dadurch gekennzeichnet, daß** die Anzahl von Empfangskanälen mindestens vier ist und daß die Abrufbefehle für die vier Empfangskanäle bzw. für die vier zuletzt im Hauptspeicher (10) abgespeicherten Empfangskanäle einem Cursorkreuz (21) zugeordnet sind.

18. Abstimmverfahren nach Anspruch 17, **dadurch gekennzeichnet, daß** die Abrufbefehle für die vier Empfangskanäle bzw. für die vier zuletzt im Hauptspeicher (10) abgespeicherten Empfangskanäle dem Cursorkreuz (21) erst durch das Betätigen einer Sondertaste (22) zugeordnet werden und daß über das Cursorkreuz (21) ansonsten andere Befehle für den Rundfunkempfänger eingegeben werden.

19. Abstimmverfahren nach einem der Ansprüche 6 bis 18, **dadurch gekennzeichnet, daß** im Hauptspeicher (10) mehr als zwei Empfangskanäle abgespeichert sind und daß durch Betätigen eines Last-Elements (23) der jüngste bzw. alternierend der jüngste und der zweitjüngste der im Hauptspeicher (10) abgespeicherten Empfangskanäle abgerufen wird bzw. werden.

20. Rundfunkempfänger, insbesondere Fernsehsignalempfänger, mit einem Permanentspeicher (3) zum Abspeichern selektierbarer Empfangskanäle, mit einem Abstimmspeicher (6), in dem einer der selektierbaren Empfangskanäle speicherbar ist, auf den der Rundfunkempfänger abzustimmen ist, mit einem Hauptspeicher (10), in dem mindestens zwei empfangene Empfangskanäle speicherbar sind, mit einer Bedieneinheit (5), mit der die im Hauptspeicher (10) gespeicherten Empfangskanäle in den Abstimmspeicher (6) ladbar sind, und mit einer Vergleichseinheit (4), die bei durch Betätigen einer +/- Taste (21) bewirkter indirekter Kanalvorgabe nach Ablauf einer Speicherzeit von mehreren Sekunden seit dem Speichern eines Empfangskanals im Abstimmspeicher (6) das Speichern des im Abstimmspeicher (6) gespeicherten Empfangskanals in den Hauptspeicher (10) bewirkt.

21. Rundfunkempfänger nach Anspruch 20, **dadurch gekennzeichnet, daß** die Vergleichseinheit (4) bei direkter Kanalvorgabe stets das Speichern des im Abstimmspeicher (6) gespeicherten Empfangskanals in den Hauptspeicher (10) bewirkt.

22. Rundfunkempfänger nach Anspruch 20 oder 21, **dadurch gekennzeichnet, daß** der Hauptspeicher (10) zwei Teilbereiche (10', 10") aufweist und daß in mindestens einem der Teilbereiche (10', 10") mindestens zwei Empfangskanäle speicherbar sind.

23. Rundfunkempfänger nach Anspruch 20, 21 oder 22, **dadurch gekennzeichnet, daß** die Bedieneinheit (5) ein Bedienelement (22) aufweist, mittels dessen die im Hauptspeicher (10) abgespeicherten Empfangskanäle zyklisch aus dem Hauptspeicher (10) abrufbar sind.

24. Rundfunkempfänger nach einem der Ansprüche 20 bis 23, **dadurch gekennzeichnet, daß** die Bedieneinheit (5) Bedienelemente (20, 21) aufweist, mittels derer die im Hauptspeicher (10) abgespeicherten Empfangskanäle direkt aus dem Hauptspeicher (10) abrufbar sind.

25. Rundfunkempfänger nach Anspruch 24, **dadurch gekennzeichnet, daß** den Bedienelementen (20, 21) eine Grundfunktion zugeordnet ist und daß die Bedieneinheit (5) ein Sonderelement (22) aufweist, mittels dessen den Bedienelementen (20, 21) die Abrufbefehle zum direkten Abrufen der im Hauptspeicher (10) abgespeicherten Empfangskanäle zuordenbar sind.

26. Rundfunkempfänger nach einem der Ansprüche 20 bis 25, **dadurch gekennzeichnet, daß** der Hauptspeicher (10) genau zwei Speicherplätze (E1, E2) zum Speichern je eines Empfangskanals aufweist.

27. Rundfunkempfänger nach einem der Ansprüche 20 bis 25, **dadurch gekennzeichnet, daß** der Hauptspeicher (10) mindestens vier Speicherplätze (E1 bis E4) zum Speichern je eines Empfangskanals aufweist und daß die Bedieneinheit (5) vier Bedienelemente (21) zum direkten Abrufen der vier Empfangskanäle bzw. der vier zuletzt im Hauptspeicher (10) abgespeicherten Empfangskanäle aufweist, die als Cursorkreuz (21) ausgebildet sein können.

28. Rundfunkempfänger nach einem der Ansprüche 20 bis 27, **dadurch gekennzeichnet, daß** die Bedieneinheit (5) ein Last-Element (23) aufweist, mittels dessen der jüngste oder alternierend der jüngste und der zweitjüngste der im Hauptspeicher (10) abgespeicherten Empfangskanäle abrufbar ist bzw. sind.

29. Rundfunkempfänger nach einem der Ansprüche 20 bis 28, **dadurch gekennzeichnet, daß** er eine Anzeigeeinheit (9) aufweist, mittels derer die im Hauptspeicher (10) abgespeicherten Empfangskanäle anzeigbar sind.

## Claims

1. Tuning method for a broadcast receiver, particularly a television signal receiver,
- wherein at least two reception channels are preset in succession at the broadcast receiver by means of a control unit (5),
- wherein the reception channels are stored in supercessionary manner in a tuning memory (6) and cumulatively in a main memory (10) until the main memory (10) is filled,
- wherein one of the reception channels stored in the main memory (10) is loadable into the tuning memory (6) on the basis of call-up commands,
- wherein the broadcast receiver is tuned in correspondence with the respective reception channel stored in the tuning memory (6),
- wherein a further reception channel, which is stored in the tuning memory (6), is preset at the broadcast receiver and
- wherein the further reception channel, when it is indirectly preset at the broadcast receiver by actuation of a +/- button (21) of the control unit (5), is, in the case of the main memory (10) being filled, stored in supercessionary manner in the main memory (10) after expiry of a storage time of several seconds since the storing of the further reception channel in the tuning memory (6).

2. Tuning method according to claim 1, **characterised in that** the further reception channel, wherein it is directly preset at the broadcast receiver, is always stored in supercessionary manner in the main memory (10).

3. Tuning method according to claim 2, **characterised in that** the number of reception channels stored in the main memory (10) is two and that the further reception channel in the case of direct channel presetting displaces one of the reception channels stored in the main memory (10) and in the case of indirect channel presetting displaces the other of the reception channels stored in the main memory (10).

4. Tuning method according to claim 3, **characterised in that** in the case of direct channel presetting the one reception channel displaces the other reception channel within the main memory (10).

5. Tuning method according to claim 3 or 4, **characterised in that** in the case of indirect channel presetting the one reception channel and the other reception channel are interchanged after expiry of an additional time which is substantially greater than the storage time.

6. Tuning method according to claim 1, **characterised in that** the further reception channel displaces the oldest of the stored reception channels.

7. Tuning method according to claim 1, **characterised in that** the main memory (10) is divided into two part regions (10', 10"), that at least two reception channels can be stored in at least one of the part regions (10', 10") and that the further reception channel in the case of direct channel presetting is stored in one of the part regions (10', 10") and in the case of indirect channel presetting is stored in the other of the part regions (10', 10").

8. Tuning method according to claim 7, **characterised in that** the reception channels have been stored in succession in the part regions (10', 10") and that the further reception channel displaces the oldest of the reception channels stored in the respective part region (10', 10").

9. Tuning method according to claim 8, **characterised in that** in the case of direct channel presetting and the other part region (10") only incompletely filled with reception channels the displaced reception channel is stored in the other part region (10") and in the case of indirect channel presetting and the one part region (10') only incompletely filled with reception channels the displaced reception channel is stored in the one part region (10').

10. Tuning method according to claim 9, **characterised in that** the displaced reception channel is stored in its new part region (10', 10") as oldest of the reception channels stored in the respective part region (10', 10").

11. Tuning method according to claim 6, 8, 9 or 10, **characterised in that** the further reception channel is called up from the main memory (10), that the further reception channel is not the youngest of the reception channels stored in the main memory (10) and that the further reception channel in the case of entry of a supplementary condition is stored as second-youngest reception channel in the main memory (10) or in a part region (10').

12. Tuning method according to one of claims 1 to 11, **characterised in that** in the case of the first input of the call-up command one of the reception channels stored in the main memory (10) is loaded into the tuning memory (6) and in the case of further inputs of the call-up command in each instance another of the reception channels stored in the main memory (10) is cyclically loaded into the tuning memory (6).

13. Tuning method according to one of claims 1 to 12, **characterised in that** the reception channels stored in the main memory (10) can be called up directly by the call-up commands.

14. Tuning method according to one of claims 1 to 13, **characterised in that** in the case of input of a display command the reception channels stored in the main memory (10) are displayed on a display unit.

15. Tuning method according to claim 13 or 14, **characterised in that** in company with a number of reception channels stored in the main memory (10) there is displayed on the display unit (9) how these reception channels can be directly called up by the call-up commands.

16. Tuning method according to claim 14 or 15, **characterised in that** in the case of a further input of the display command the display of the reception channels stored in the main memory (10) is extinguished again.

17. Tuning method according to claim 14, 15 or 16, **characterised in that** the number of reception channels is at least four and that the call-up commands for the four reception channels or for the four reception channels last stored in the main memory (10) are associated with a cursor cross (21).

18. Tuning method according to claim 17, **characterised in that** the call-up commands for the four reception channels or for the four reception channels last stored in the main memory (10) are associated with the cursor cross (21) only by actuation of a special button (22) and that other commands for the broadcast receiver are otherwise input by way of the cursor cross (21).

19. Tuning method according to one of claims 6 to 18, **characterised in that** more than two reception channels are stored in the main memory (10) and that the youngest or alternatively the youngest and the second-youngest of the reception channels stored in the main memory (10) is or are called up by actuation of a 'last' element (23).

20. Broadcast receiver, particularly television signal receiver, with a permanent memory (3) for storage of selectable reception channels, with a tuning memory (6) in which one of the selectable reception channels, to which the broadcast receiver is to be tuned, can be stored, with a main memory (10) in which at least two received reception channels can be stored, with a control unit (5) by which the reception channels stored in the main memory (10) can be loaded into the tuning memory (6), and with a comparison unit (4) which in the case of indirect channel presetting effected by actuation of a +/- button (21) causes storage in the main memory (10) of the reception channel, which is stored in the tuning memory (6), after expiry of a storage time of several seconds since the storing of a reception channel in the tuning memory (6).

21. Broadcast receiver according to claim 20, **characterised in that** the comparison unit (4) in the case of direct channel presetting always causes storage in the main memory (10) of the reception channel stored in the tuning memory (6).

22. Broadcast receiver according to claim 20 or 21, **characterised in that** the main memory (10) comprises two part regions (10', 10") and that least two reception channels can be stored in at least one of the part regions (10', 10").

23. Broadcast receiver according to claim 20, 21 or 22, **characterised in that** the control unit (5) comprises a control element (22), by means of which the reception channels stored in the main memory (10) can be cyclically called up from the main memory (10).

24. Broadcast receiver according to one of claims 20 to 23, **characterised in that** the control unit (5) comprises control elements (20, 21), by means of which the reception channels stored in the main memory (10) can be called up directly from the main memory (10).

25. Broadcast receiver according to claim 24, **characterised in that** a basic function is associated with the control elements (20, 21) and that the control unit (5) has a specific element (22) by means of which the call-up commands for direct calling-up of the reception channels stored in the main memory (10) can be assigned to the control elements (20, 21).

26. Broadcast receiver according to one of claims 20 to 25, **characterised in that** the main memory (10) has exactly two memory locations (E1, E2) each for storage of a respective reception channel.

27. Broadcast receiver according to one of claims 20 to 25, **characterised in that** the main memory (10) has at least four memory locations (E1 to E4) each for storage of a respective reception channel and that the control unit (5) has four control elements (21) for direct calling-up of the four reception channels or the four reception channels last stored in the main memory (10), wherein the control elements can be formed as a cursor cross (21).

28. Broadcast receiver according to one of claims 20 to 27, **characterised in that** the control unit (5) comprises a 'last' element (23), by means of which the youngest or alternatively the youngest and the second-youngest of the reception channels stored in the main memory (10) can be called up.

29. Broadcast receiver according to one of claims 20 to 28, **characterised in that** it comprises a display unit (9), by means of which the reception channels stored in the main memory (10) can be displayed.

## Revendications

1. Procédé de syntonisation pour un récepteur radio, notamment un récepteur de signaux de télévision,
- selon lequel au moins deux canaux de réception sont prédéterminés successivement pour le récepteur radio à l'aide d'une unité de commande (5),
- selon lequel les canaux de réception sont mémorisés avec substitution dans une mémoire de syntonisation (6) et de façon cumulée dans une mémoire principale (10), jusqu'à ce que la mémoire principale (10) soit remplie,
- selon lequel en raison d'instructions d'appel, l'un des canaux de réception mémorisés dans la mémoire principale (10) peut être chargé dans la mémoire de syntonisation (6),
- selon lequel le récepteur radio est syntonisé conformément au canal de réception respectivement mémorisé dans la mémoire de syntonisation (6),
- selon lequel un autre canal de réception, qui est mémorisé dans la mémoire de syntonisation (6), est prédéterminé pour le récepteur radio,
- selon lequel lorsque l'autre canal de réception est prédéterminé de façon indirecte pour le récepteur par actionnement d'une touche +/- (21) de l'unité de commande (5), lorsque la mémoire principale(10) est remplie, l'autre canal de réception est mémorisé avec substitution dans la mémoire principale (10) après l'écoulement d'un intervalle de temps de mémorisation de plusieurs secondes après la mémorisation de l'autre canal de réception dans la mémoire de syntonisation (6).

2. Procédé de syntonisation selon la revendication 1, **caractérisé en ce que**, lorsque l'autre canal de réception est prédéterminé directement pour le récepteur radio, l'autre canal de réception est mémorisé en permanence avec substitution dans la mémoire principale (10).

3. Procédé de syntonisation selon la revendication 2, **caractérisé en ce que** le nombre de canaux de réception mémorisés dans la mémoire principale (10) est égal à deux et que dans le cas d'une prédétermination directe du canal, l'autre canal de réception est substitué à l'un des deux canaux de réception, et, dans le cas d'une prédétermination indirecte du canal, le canal de réception mémorisé dans la mémoire principale (10) est substitué à l'autre de ces canaux.

4. Procédé de syntonisation selon la revendication 3, **caractérisé en ce que** dans le cas d'une prédétermination directe du canal, un canal de réception est substitué à l'autre canal de réception à l'intérieur de la mémoire principale (10).

5. Procédé de syntonisation selon la revendication 3 ou 4, **caractérisé en ce que** dans le cas d'une prédétermination indirecte du canal, après l'écoulement d'un intervalle de temps supplémentaire qui est nettement supérieur à la durée de mémorisation, le canal de réception et l'autre canal de réception sont permutés.

6. Procédé de syntonisation selon la revendication 1, **caractérisé en ce que** l'autre canal de réception est substitué au plus ancien des canaux de réception mémorisés.

7. Procédé de syntonisation selon la revendication 1, **caractérisé en ce que** la mémoire principale (10) est divisée en deux zones partielles (10', 10"), qu'au moins deux canaux de réception peuvent être mémorisés dans au moins l'une des zones partielles (10', 10") et que l'autre canal de réception est mémorisé, dans le cas d'une prédétermination directe du canal, dans l'une des zones partielles (10', 10") et, dans le cas d'une prédétermination indirecte du canal, dans l'autre des zones partielles (10', 10").

8. Procédé de syntonisation selon la revendication 7, **caractérisé en ce que** les canaux de réception ont été mémorisés successivement dans les zones partielles (10, 10") et que l'autre canal de réception est substitué au plus ancien des canaux de réception mémorisés dans la zone partielle respective.

9. Procédé de syntonisation selon la revendication 8, **caractérisé en ce que**, dans le cas d'une prédétermination directe du canal et dans le cas où l'autre zone partielle (10") est seulement incomplètement remplie par des canaux de réception, le canal de réception substitué est mémorisé dans l'autre zone partielle (10") et, dans le cas d'une prédétermination indirecte du canal, et dans le cas où une zone partielle (10') est seulement incomplètement remplie par les canaux de réception, le canal de réception substitué est mémorisé dans une zone partielle (10').

10. Procédé de syntonisation selon la revendication 9, **caractérisé en ce que** le canal de réception substitué est mémorisé dans sa nouvelle zone partielle (10', 10") comme étant le plus ancien des canaux de réception mémorisés dans la zone partielle respective (10', 10").

11. Procédé de syntonisation selon la revendication 6, 8, 9 ou 10, **caractérisé en ce que** l'autre canal est appelé à partir de la mémoire principale (10), que l'autre canal de réception n'est pas le plus récent des canaux de réception mémorisés dans la mémoire principale (10) et que lors de l'apparition d'une condition de complémentation, l'autre canal de réception est mémorisé en tant que canal de réception le plus récent en second dans la mémoire principale (10) ou dans une zone partielle (10').

12. Procédé de syntonisation selon l'une des revendications 1 à 11, **caractérisé en ce que** lors de la première introduction de l'instruction d'appel, un des canaux de réception mémorisés dans la mémoire principale (10) et dans le cas d'autres entrées de l'instruction d'appel, cycliquement respectivement un autre des canaux de réception mémorisés dans la mémoire principale (10) est chargé dans la mémoire de syntonisation (6).

13. Procédé de syntonisation selon l'une des revendications 1 à 12, **caractérisé en ce que** les canaux de réception mémorisés dans la mémoire principale (10) peuvent être appelés directement par les instructions d'appel.

14. Procédé de syntonisation selon l'une des revendications 1 à 13, **caractérisé en ce que** lors de l'introduction d'une instruction d'affichage, les canaux de réception mémorisés dans la mémoire principale (10) sont affichés sur une unité d'affichage.

15. Procédé de syntonisation selon la revendication 13 ou 14, **caractérisé en ce que** conjointement avec un nombre de canaux de réception mémorisés dans la mémoire principale (10), il est indiqué, sur l'unité d'affichage (9), comment ces canaux de réception peuvent être appelés directement par les instructions d'appel.

16. Procédé de syntonisation selon la revendication 14 ou 15, **caractérisé en ce que** dans le cas d'une entrée supplémentaire de l'instruction d'affichage, l'affichage des canaux de réception mémorisés dans la mémoire principale (10) est à nouveau effacé.

17. Procédé de syntonisation selon la revendication 14,15 ou 16, **caractérisé en ce que** le nombre de canaux de réception est égal au moins à quatre et que les instructions d'appel pour les quatre canaux de réception ou pour les quatre canaux de réception mémorisés en dernier dans la mémoire principale (10) sont associés à une croix de curseurs (21).

18. Procédé de syntonisation selon la revendication 17, **caractérisé en ce que** les instructions d'appel pour les quatre canaux de réception ou pour les quatre canaux de réception mémorisés en dernier lieu dans la mémoire principale (10) sont associés à la croix de curseurs (21) uniquement au moyen de l'actionnement d'une touche particulière (22) et que sinon d'autres instructions pour le récepteur radio sont introduites au moyen de la croix de curseurs (21).

19. Procédé de syntonisation selon l'une des revendications 6 à 18, **caractérisé en ce que** plus de deux canaux de réception sont mémorisés dans la mémoire principale (10) et que sous l'effet de l'actionnement d'un élément de charge (23), le plus récent ou sinon le plus récent et le plus récent en second des canaux de réception mémorisés dans la mémoire principale (10) est(sont) appelé(s).

20. Récepteur radio, notamment récepteur de signaux de télévision, comportant une mémoire permanente (3) pour mémoriser les canaux de réception pouvant être sélectionnés, une mémoire de syntonisation (6) dans laquelle peut être mémorisé l'un des canaux de réception pouvant être sélectionnés, sur lequel le récepteur radio doit être réglé, une mémoire principale (10) dans laquelle au moins deux canaux de réception reçus peuvent être mémorisés, une unité de commande (5), au moyen de laquelle les canaux de réception mémorisés dans la mémoire principale (10) peuvent être chargés dans la mémoire de syntonisation (6), et une unité de comparaison (4), qui lors de la prédétermination indirecte du canal, réalisée par actionnement d'une touche +/- (21), réalise, après l'écoulement d'une durée de mémorisation de plusieurs secondes à partir de la mémorisation d'un canal de réception dans la mémoire de syntonisation (6), la mémorisation du canal de réception, mémorisé dans la mémoire de syntonisation (6), dans la mémoire principale (10).

21. Récepteur radio selon la revendication 20, **caractérisé en ce que** dans le cas d'une prédétermination directe du canal, l'unité de comparaison (4) réalise en permanence la mémorisation du canal de réception, mémorisé dans la mémoire de syntonisation (6), dans la mémoire principale (10).

22. Récepteur radio selon la revendication 20 ou 21, **caractérisé en ce que** la mémoire principale (10) comporte deux zones partielles (10', 10") et qu'au moins deux canaux de réception peuvent être mémorisés dans au moins l'une des zones partielles (10', 10").

23. Récepteur radio selon la revendication 20, 21 ou 22, **caractérisé en ce que** l'unité de commande (5) comporte un élément de commande (22), à l'aide duquel les canaux de réception mémorisés dans la mémoire principale (10) peuvent être appelés cycliquement à partir de la mémoire principale (10).

24. Récepteur radio selon l'une des revendications 20 à 23, **caractérisé en ce que** l'unité de commande (5) comporte des éléments de commande (20, 21), à l'aide desquels les canaux de réception mémorisés dans la mémoire principale (10) peuvent être appelés directement à partir de la mémoire principale (10).

25. Récepteur radio selon la revendication 24, **caractérisé en ce que** la fonction de base est associée aux éléments de commande (20, 21) et que l'unité de commande (5) comporte un élément particulier (22), à l'aide duquel les instructions d'appel peuvent être associées aux éléments de commande (20, 21) pour l'appel direct des canaux de réception mémorisé dans la mémoire principale (10).

26. Récepteur radio selon l'une des revendications 20 à 25, **caractérisé en ce que** la mémoire principale (10) comporte précisément deux emplacements de mémoire (E1, E2) pour la mémorisation d'un canal de réception respectif.

27. Récepteur radio selon l'une des revendications 20 à 25, **caractérisé en ce que** la mémoire principale (10) comporte au moins quatre emplacements de mémoire (E1 à E4) pour mémoriser respectivement un canal de réception, et que l'unité de commande (5) comporte quatre éléments de commande (21) pour appeler directement les quatre canaux de réception ou les quatre canaux de réception mémorisés en dernier lieu dans la mémoire principale (10) et qui peuvent être agencés sous la forme d'une croix de curseurs (21).

28. Récepteur radio selon l'une des revendications 20 à 27, **caractérisé en ce que** l'unité de commande (5) comporte un élément de charge (23), à l'aide duquel le canal de réception le plus récent ou sinon le canal le plus récent et le canal le plus récent en second parmi les canaux de réception mémorisés dans la mémoire principale (10) peut(peuvent) être appelé(s).

29. Récepteur radio selon l'une des revendications 20 à 28, **caractérisé en ce qu'**il comporte une unité d'affichage (9), au moyen de laquelle les canaux de réception mémorisés dans la mémoire principale (10) peuvent être affichés.
